# DEMANDE DE BREVET EUROPEEN

(11) **EP 1 394 845 A2**
(43) Date de publication de la demande: **03.03.2004**
(21) Numéro de dépôt: 03292029.0
(22) Date de dépôt: 13.08.2003
(51) Int. Cl.: H01L 21/321

(54) **Procédé de fabrication d'un circuit électrique comprenant une étape de polissage**

(30) Priorité: 30.08.2002 FR 0210779
(71) Demandeur: STMicroelectronics S.A., 92120 Montrouge (FR); Koninklijke Philips Electronics N.V., 5621 BA Eindhoven (NL)
(72) Inventeur: Kordic, Srdjan, 38190 Bernin (FR); Inard, Alain, 38330 St. Nazaire les Eynes (FR); Roussel, Céline, 38400 St. Martin d'Heres (FR); Gayet, Philippe, 38660 St. Vincent de Mercuze (FR)
(74) Mandataire: Hassine, Albert

(57) **Abrégé**

Un procédé de fabrication d'un circuit électrique intégré comprend la formation puis le retrait d'inserts conducteurs. Des composants (10, 20) du circuit électrique sont incorporés dans des matériaux isolants (2, 4) superposés au dessus d'un substrat (1). Le procédé permet l'aménagement d'un volume d'exclusion autour de certains composants sensibles (10) aux couplages électrostatiques tout en conférant une surface (S2) plane à chaque matériau isolant à l'issue d'une étape de polissage.

## Description

La présente invention concerne le procédé de fabrication de circuits électriques intégrés de type Damascène ou analogue.

Selon le procédé Damascène, des circuits électriques comprenant des connexions métalliques sont agencés au sein d'une couche de matériau isolant électrique présente sur une surface d'un substrat. Lors d'une première étape du procédé, cette couche est gravée au niveau d'une surface de cette couche opposée au substrat, de façon à réaliser des tranchées correspondant aux connexions destinées à être élaborées. Lors d'une seconde étape, la couche de matériau isolant est recouverte d'un dépôt de matériau métallique, tel que le cuivre, de façon à combler les tranchées. Un polissage est ensuite opéré de façon à éliminer un surplus du matériau métallique au-dessus de la couche de matériau isolant. Le procédé de fabrication du circuit électrique comprend en outre de nombreuses autres étapes connues de l'homme de métier, notamment des étapes d'élaboration de composants semi-conducteurs tels que des transistors ou des diodes.

Un circuit électrique complet réalisé sur une surface d'un substrat comprend en général plusieurs couches superposées de matériau isolant électrique, chacune d'elles incorporant des parties métalliques. Chaque couche est élaborée selon le procédé Damascène précédent, qui est exécuté à plusieurs reprises de façon à obtenir successivement toutes les couches, et ce, par exemple, jusqu'à huit ou neuf couches superposées.

Le procédé «dual Damascène» constitue une variante connue du procédé Damascène. Dans cette variante, les tranchées gravées au sein de la couche de matériau isolant sont réparties selon deux niveaux dans l'épaisseur de cette couche. Les tranchées des deux niveaux sont comblées de matériau métallique lors d'une étape unique de dépôt de ce matériau métallique. Les tranchées comblées appartenant au niveau inférieur, le plus proche du substrat, sont en général destinées à constituer des connexions électriques selon une direction perpendiculaire à la surface du substrat, communément désignées par «vias». Les tranchées comblées appartenant au niveau supérieur, le plus éloigné du substrat, sont notamment destinées à constituer des connexions électriques selon des directions parallèles à la surface du substrat, appelées couramment pistes. La présente invention s'applique de façon identique au procédé Damascène tel que présenté en premier, ou au procédé «dual Damascène».

Outre l'obtention de connexions métalliques, les tranchées réalisées dans le matériau isolant électrique peuvent être destinées à l'élaboration de composants électriques particuliers tels que des bobines, ou inductances, notamment RF, des antennes, des lignes de transport rapide de signaux électriques, ou encore des condensateurs ayant des armatures de grandes dimensions. Les contours de certaines des tranchées gravées sont alors adaptés pour correspondre à ces composants. Dans le cas du procédé «dual Damascène», de tels composants sont en général disposés dans le niveau supérieur de la couche de matériau isolant.

Pour certaines applications, des composants tels des inductances, des antennes, des lignes de transport rapide de signaux ou des grands condensateurs nécessitent qu'aucune autre partie conductrice ne soit présente dans un voisinage de chacun de ces composants. En effet, ces composants sont sensibles aux couplages électrostatiques du type capacitif et aux couplages inductifs, et leur fonctionnement propre, ou le fonctionnement des circuits qui incorporent ces composants, s'en trouve affecté. Un volume d'exclusion de parties conductrices est alors ménagé autour de ces composants, c'est-à-dire, au dessous et au dessus de ces composants et parallèlement à la surface du substrat. De façon usuelle, le volume d'exclusion correspond à une distance minimale de plusieurs dizaines de microns à partir du contour du composant sensible aux couplages électrostatiques.

Le volume d'exclusion est occupé par le ou les matériaux isolants utilisés. Ces matériaux isolants peuvent varier entre deux couches successives, mais la silice SiO₂ est le plus souvent utilisée, ou encore des matériaux à plus basse permittivité diélectrique de type oxycarbure de silicium (SiOC). Eventuellement, chaque couche de matériau isolant peut contenir des parties constituées d'un matériau isolant différent, tel que, par exemple, le nitrure de silicium Si₃N₄ ou le carbure de silicium (SiC). Ceci est par exemple en particulier le cas dans le procédé «dual Damascène», dans lequel les niveaux inférieur et supérieur de tranchées gravées dans une même couche de matériau isolant, par exemple de silice, sont séparés par une barrière de nitrure de silicium parallèle à la surface du substrat. Cette barrière de nitrure de silicium sépare l'une de l'autre deux parties superposées de la même couche de matériau isolant, et ce en dehors de zones correspondant à des tranchées du niveau inférieur. De façon connue de l'homme du métier, une telle barrière de nitrure de silicium permet de graver lors d'une unique étape de gravure les tranchées des deux niveaux au sein de la couche de matériau isolant électrique.

Le volume d'exclusion entourant certains composants sensibles engendre une disproportion entre les fractions respectives du matériau isolant et du matériau métallique au sein de chaque couche. En effet, chaque couche est exclusivement constituée de matériau isolant au niveau du volume d'exclusion, en dehors du composant sensible, alors qu'elle comporte une fraction de matériau métallique dans les zones où sont répartis d'autres composants électriques.

L'étape de polissage des procédés Damascène et « dual Damascène » utilise un liquide de polissage, appelé «slurry», et des grains abrasifs. Le liquide de polissage est introduit entre la surface destinée à être polie et un disque motorisé qui possède en général une surface plane et qui est mis en rotation dans le plan de cette surface. Les grains abrasifs, par exemple des grains d'alumine, sont soit libres dans le liquide de polissage, soit fixés sur la surface du disque motorisé. La surface du disque motorisé est appliquée avec une force de pression contrôlée contre la surface du substrat portant le matériau isolant recouvert de matériau métallique. L'objectif du polissage est d'éliminer le surplus de matériau métallique déposé sur le matériau isolant, de façon à découvrir des parties du matériau isolant entre les tranchées qui restent comblées de matériau métallique.

Afin de réduire la durée du polissage, le liquide de polissage comprend des agents chimiques actifs vis-à-vis du matériau métallique. Ces agents chimiques modifient la surface du matériau métallique en formant un composé complexe avec certains composants du matériau métallique. Ce composé complexe est ensuite rapidement retiré de la surface polie par l'action mécanique du polissage. Le surplus de matériau métallique peut ainsi être éliminé rapidement jusqu'à l'apparition de portions découvertes de la surface du matériau isolant. Le matériau isolant n'est retiré que lentement par le polissage, du fait de l'absence de composé complexe formé par des agents du liquide de polissage avec des composants du matériau isolant. Ainsi, une vitesse d'enlèvement du matériau métallique de l'ordre de 5 à 30 fois supérieure à la vitesse d'enlèvement du matériau isolant est obtenue.

A cause de cette différence entre les vitesses d'enlèvement du matériau métallique et du matériau isolant, des portions de matériau isolant qui incorporent des fractions différentes de matériau métallique présentent des vitesses d'enlèvement de matière distinctes. De ce fait, à la fin d'une étape de polissage, lorsque la surface découverte comprend des zones de matériau métallique et des zones de matériau isolant, un enlèvement de matière plus rapide, et donc plus important, se produit dans les zones de matériau métallique, provoquant un défaut de planéité de la surface en cours de polissage.

Une telle perte de planéité de la surface du matériau isolant intervient notamment à proximité des volumes d'exclusion associés à certains composants. A l'issue du polissage, la surface supérieure du matériau isolant dans les volumes d'exclusion apparaît en relief par rapport à la surface supérieure environnante du matériau isolant qui incorpore des parties de matériau métallique, créant une marche ou un dénivelé dans cette surface. Cette marche ou dénivelé peut atteindre 50 nanomètres de hauteur ou plus, et provoque alors l'existence de parties du surplus de matériau métallique qui ne peuvent être retirées lors du polissage, du fait que les grains abrasifs ne peuvent atteindre l'angle interne de la marche. De telles parties de surplus de matériau métallique qui restent à l'issue du polissage peuvent s'étendre jusqu'à 200 µm de la marche et provoquent des courts-circuits et des claquages lors de l'utilisation du circuit électrique.

US 6 232 231 propose de réduire sinon de supprimer l'écart de vitesse d'enlèvement de matière en disposant des inserts métalliques dans les parties de couche de matériau isolant dépourvues de circuits métalliques. Ces inserts, ou «dummies», ne possèdent aucune fonction dans le circuit électrique et sont isolés électriquement de celui-ci, notamment des parties métalliques fonctionnelles de ce circuit. Ils sont réalisés lors des mêmes étapes du procédé Damascène que les connexions métalliques, à savoir lors des étapes de gravure de la couche de matériau isolant, de remplissage par du matériau métallique et de polissage. Ces inserts métalliques ont pour fonction de réduire la disproportion de fraction de matériau métallique entre différentes portions du matériau isolant.

II est aussi connu de combiner de tels inserts métalliques avec le procédé «dual Damascène» (US 6 214 745).

Cette première méthode de suppression des risques de courts-circuits et de claquages est incompatible avec le volume d'exclusion qui entoure des composants sensibles aux couplages électrostatiques, puisque les inserts eux-mêmes sont des parties métalliques et sont, de ce fait, proscrites du volume d'exclusion.

Une seconde méthode de suppression des risques de courts-circuits et de claquages autour du volume d'exclusion consiste à ménager un volume d'exclusion complémentaire. De façon usuelle, un tel volume d'exclusion complémentaire porte à 200 µm la distance minimale séparant certains composants métalliques du composant sensible aux couplages électrostatiques. Cette seconde méthode, bien qu'efficace, a pour inconvénient de créer un important volume inexploité vis-à-vis de l'élaboration de composants au dessus du substrat, ce qui correspond à un surcoût du circuit électrique.

Un but de la présente invention est de réduire le défaut de planéité créé lors du polissage en présence de volumes d'exclusion, tout en minimisant ces volumes inexploités.

L'invention propose un procédé de fabrication d'un circuit électrique, dans lequel on exécute des traitements par couche successifs au-dessus d'un substrat pour réaliser au moins un premier composant dans une première portion du circuit et des seconds composants dans une seconde portion du circuit adjacente à la première portion.

Dans ce procédé, au moins un premier des traitements par couche comprend les étapes suivantes :
- former dans un premier matériau isolant électrique présent au-dessus du substrat, des cavités de compensation dans la première portion du circuit et des tranchées correspondant à certains au moins des seconds composants dans la seconde portion du circuit ;
- recouvrir le premier matériau isolant d'un premier matériau conducteur de façon à remplir sensiblement les cavités de compensation et les tranchées formées dans le premier matériau isolant ;
- polir le premier matériau conducteur jusqu'à découvrir une partie du premier matériau isolant dans la seconde portion ; et
- enlever le premier matériau conducteur dans la première portion,
et au moins un second des traitements par couche comprend les étapes suivantes :
- former, dans un second matériau isolant électrique présent au-dessus du substrat, au moins une tranchée correspondant au premier composant dans la première portion du circuit ;
- recouvrir le second matériau isolant d'un second matériau conducteur de façon à remplir sensiblement la tranchée formée dans la première portion ; et
- retirer partiellement le second matériau métallique jusqu'à découvrir une partie du second matériau isolant dans la première portion.

Ainsi, des inserts conducteurs pouvant être métalliques et correspondant aux cavités de compensation comblées sont temporairement créés dans le premier matériau isolant. Ces inserts temporaires permettent de conférer au premier matériau isolant une surface supérieure sensiblement plane à l'issue du polissage dudit premier matériau conducteur, c'est-à-dire une surface qui ne présente pas de variation de hauteur supérieure à 30-50 nanomètres environ par rapport à la surface du substrat. Les inserts sont ensuite retirés de façon à former un volume d'exclusion autour du premier composant.

Un avantage du procédé réside dans l'absence de volume d'exclusion complémentaire qui s'ajoute au volume d'exclusion ménagé autour d'un composant sensible aux couplages électrostatiques.

Dans une réalisation typique, ledit premier traitement par couche est exécuté avant ledit second traitement par couche, le second matériau isolant étant déposé par dessus le premier matériau isolant.

Le premier ou second matériau isolant présent en surface du substrat et traité en premier peut être partie intégrante du substrat ou être déposé sur la surface de celui-ci sous forme d'une couche formée dans les première et seconde portions du circuit. Ce dépôt est alors effectué lors d'une étape préalable à l'ensemble des traitements par couche précédents. Ainsi un substrat quelconque peut être utilisé pour l'élaboration du circuit électrique, notamment un substrat qui ne présente pas initialement de matériau isolant au niveau de sa surface.

Lors du traitement par couche associé au second matériau isolant, le retrait partiel du second matériau conducteur peut être effectué selon différentes méthodes, notamment en utilisant un polissage, une gravure chimique au moyen d'une solution liquide ou une gravure sèche par plasma. Ces mêmes méthodes de retrait peuvent aussi être utilisées pour l'enlèvement du premier matériau conducteur dans la première portion du circuit effectué lors du traitement par couche associé au premier matériau isolant. Pour certaines de ces méthodes, il peut être utile que les cavités de compensation formées dans le premier matériau isolant aient une profondeur plus petite que les tranchées formées dans le premier matériau isolant.

Dans une variante, au moins un troisième des traitements par couche comprend les étapes suivantes :
- former, dans un troisième matériau isolant électrique présent au dessus du substrat, des tranchées correspondant à des seconds composants dans la seconde portion du circuit ;
- recouvrir le troisième matériau isolant d'un troisième matériau conducteur de façon à remplir sensiblement les tranchées formées dans le troisième matériau isolant ;
- polir le troisième matériau conducteur jusqu'à découvrir une partie du troisième matériau isolant dans la seconde portion, de telle sorte que la surface du troisième matériau isolant se retrouve plus haute dans la première portion que dans la seconde portion ;
- graver des premières cavités dans le troisième matériau isolant dans la première portion du circuit, de façon telle que les premières cavités aient leurs fonds plus profonds que le niveau de ladite surface du troisième matériau isolant dans la seconde portion du circuit.

Dans cette variante, ledit premier traitement par couche, exécuté après ledit troisième traitement par couche, commence par une étape de dépôt du premier matériau isolant sous forme d'une couche recouvrant le troisième matériau isolant dans les première et seconde portions du circuit de façon que la surface du premier matériau isolant présente des secondes cavités sensiblement conformes aux premières cavités et constituant lesdites cavités de compensation.

L'invention concerne aussi un circuit électrique fabriqué selon un procédé tel que décrit précédemment. Un tel circuit, lorsqu'il est reproduit pour une fabrication en grande série, présente une fidélité de reproduction améliorée au niveau de la superposition des couches et un risque réduit d'apparition de court-circuit lors de son utilisation.

L'invention concerne encore un dispositif comprenant un tel circuit électrique. Ce dispositif peut être, par exemple, une unité informatique ou une unité de communication mobile telle qu'un téléphone portable.

D'autres particularités et avantages de la présente invention apparaîtront dans la description ci-après d'exemples de mise en oeuvre non limitatifs, en référence aux dessins annexés, dans lesquels :
- les figures 1-a à 1-f illustrent des étapes d'une première mise en oeuvre du procédé de l'invention ;
- la figure 2-a représente un exemple de structure fabriquée selon le procédé de l'invention ;

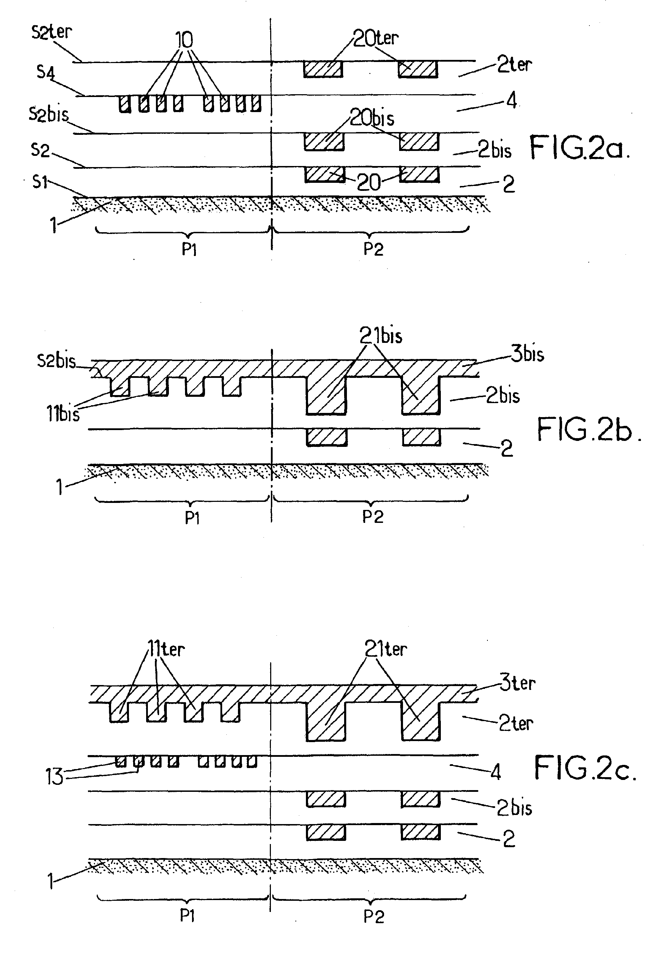

- les figures 2-b et 2-c illustrent deux étapes d'une seconde mise en oeuvre du procédé de l'invention adaptée pour obtenir la structure de la figure 2-a ;

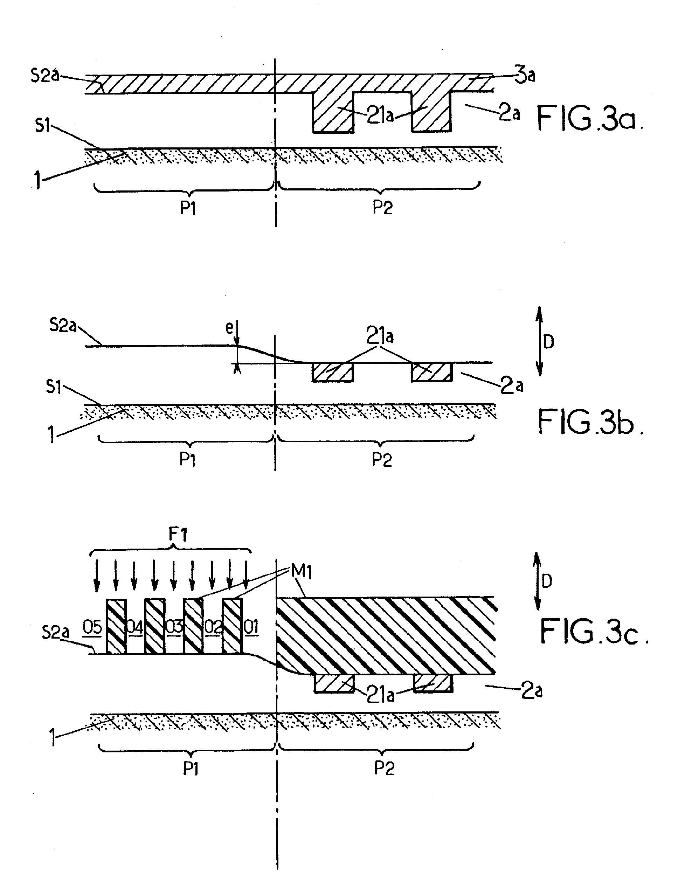

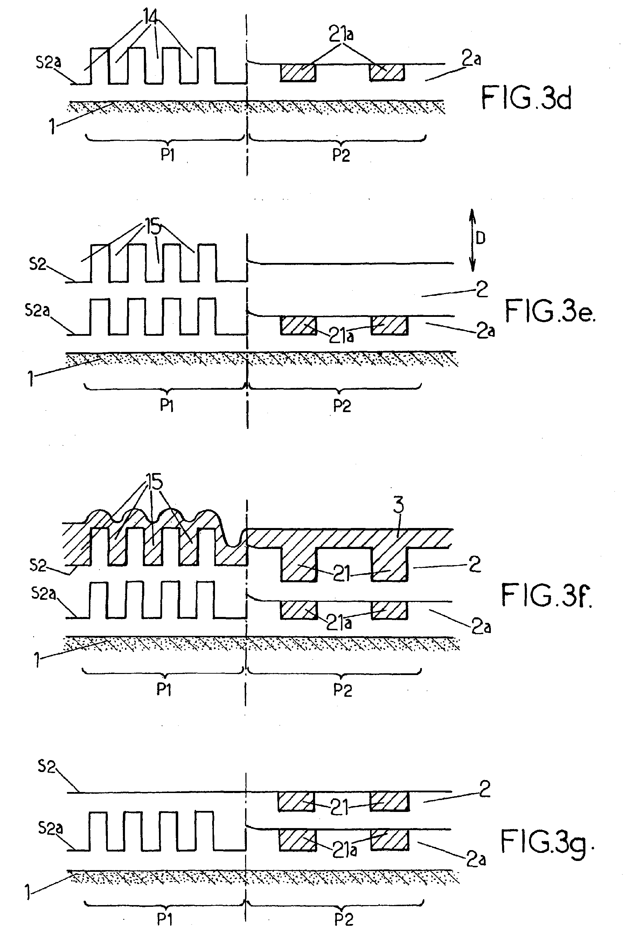

- les figures 3-a à 3-g illustrent des étapes d'une variante du procédé de l'invention ;

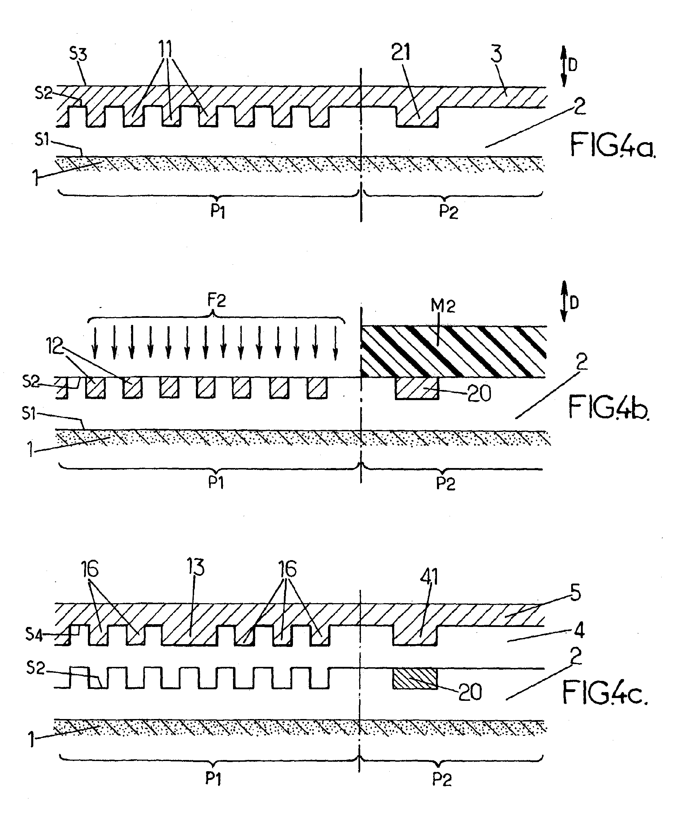

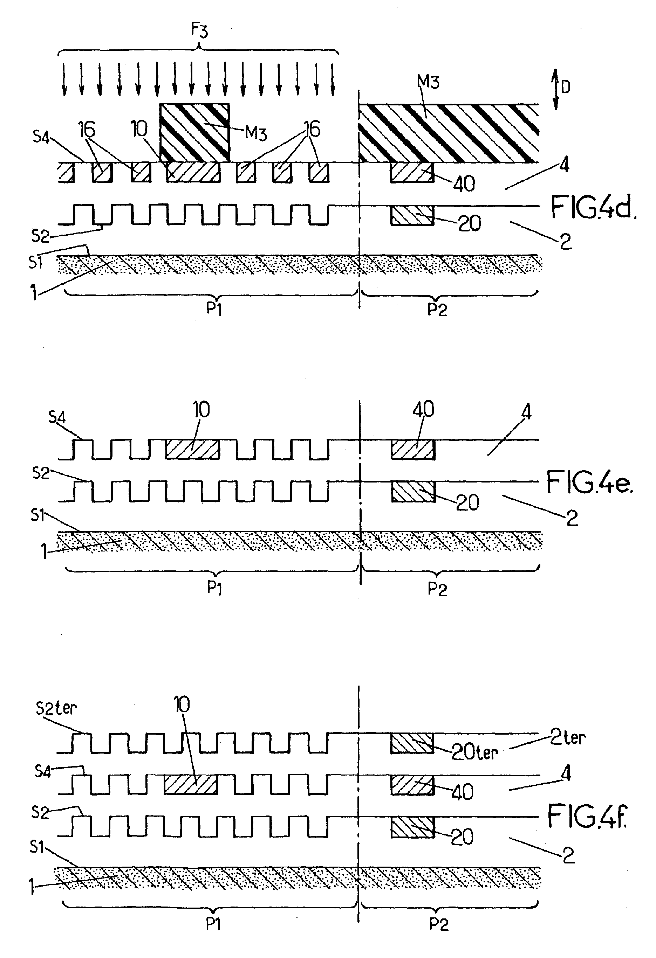

- les figures 4-a à 4-f illustrent des étapes d'une troisième mise en oeuvre du procédé de l'invention ;

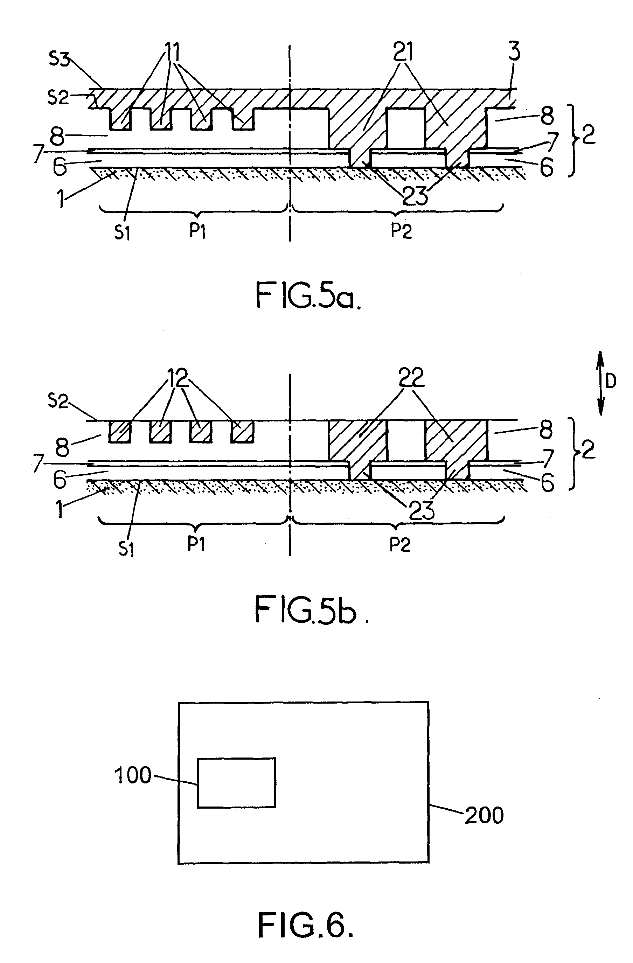

- les figures 5-a et 5-b illustrent deux étapes de la première mise en oeuvre du procédé de l'invention combinée avec le procédé «dual Damascène»;
- la figure 6 est un schéma synoptique d'un dispositif selon l'invention.

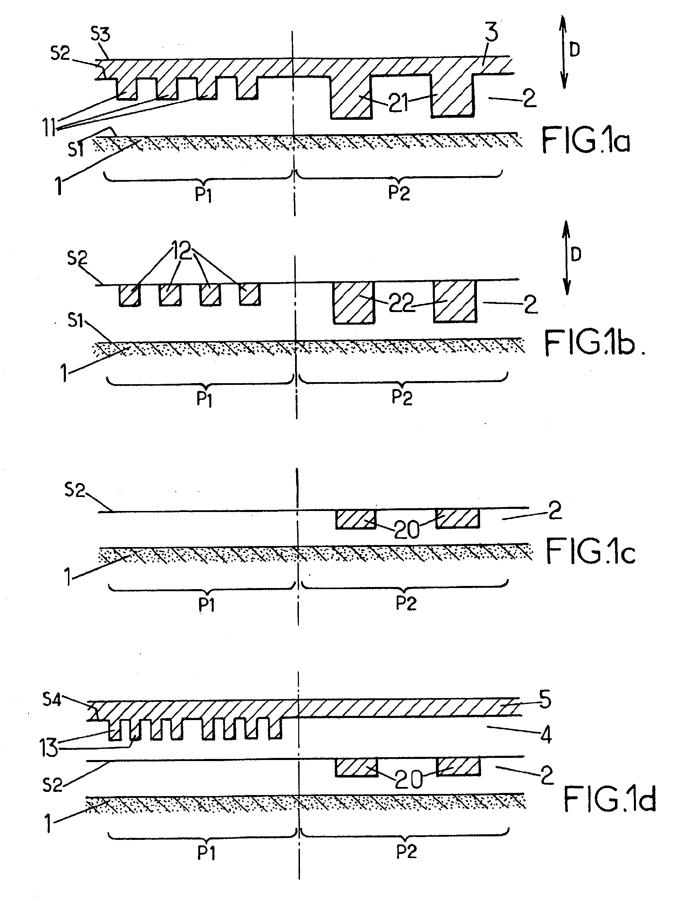

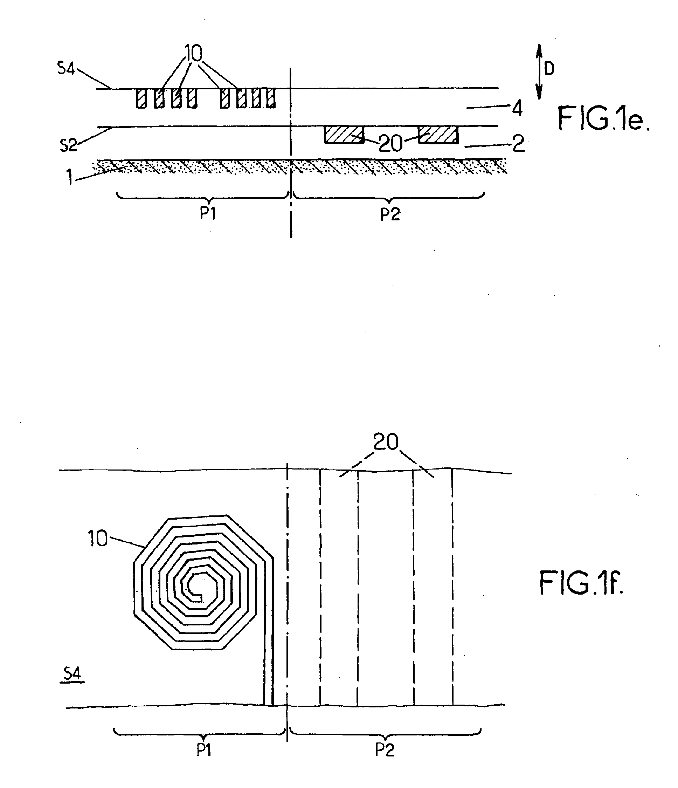

Toutes ces figures, hormis la figure 1-f, sont des vues en coupe de substrats plans sur lesquels sont élaborées des couches incorporant des composants métalliques. Une surface S1 de chacun de ces substrats qui porte la structure est prise orientée vers le haut des figures. Les mots «sur», «sous», «au-dessus de», «supérieur», et «inférieur» utilisés dans la suite le sont en référence à cette orientation. On désigne par D une direction perpendiculaire à la surface S1. Sur toutes les figures, les proportions entre des parties différentes d'éléments représentés ne sont pas en correspondance avec des dimensions réelles, afin de procurer une meilleure lisibilité. Par ailleurs, des mêmes références numériques reprises sur deux figures distinctes correspondent à des significations identiques.

La figure 1-a représente un substrat 1, par exemple de silicium, portant sur une surface plane S1 une couche 2 de matériau isolant, par exemple de silice SiO₂. La couche 2 est obtenue au moyen de l'une des méthodes connues de l'homme du métier, particulièrement adaptée pour la réalisation de dépôts de silice avec une durée de dépôt réduite. De telles méthodes sont, par exemple, le dépôt chimique en phase vapeur («Chemical Vapour Deposition» ou CVD) ou le dépôt chimique activé par plasma («Plasma Enhanced Chemical Vapour Deposition» ou PECVD) qui utilisent, par exemple, le composé tétraéthoxysilane Si-(OC₂H₅)₄ (ou TEOS) comme réactif principal. La couche 2 présente une épaisseur de plusieurs centaines de nanomètres, par exemple.

Des cavités de compensation 11 et des tranchées 21 sont alors gravées dans la couche de silice 2, au niveau de la surface supérieure S2 la couche 2. La gravure des cavités 11 et des tranchées 21 est effectuée en utilisant l'une des méthodes connues de l'homme du métier, telle que la gravure par plasma, dite «gravure sèche», ou la gravure par solution chimique, dite «gravure humide». Des masques, non représentés, sont déposés successivement sur la surface S2 pour définir les contours des cavités 11 et des tranchées 21 dans le plan de la surface S2. L'utilisation de ces masques permet aussi, selon la figure 1-a, de graver les cavités 11 jusqu'à une profondeur selon la direction D inférieure à la profondeur des tranchées 21 selon la direction D.

Les cavités 11 sont destinées à la réalisation, lors d'une étape ultérieure du procédé, d'inserts métalliques répartis dans une portion P1 du circuit. Elles ont, par exemple, une profondeur de quelques centaines de nanomètres, ou moins. Le masque utilisé pour la gravure des cavités 11 est retiré après cette gravure.

Les tranchées 21 sont destinées à l'élaboration de composants métalliques du type pistes ou «vias» dans une seconde portion P2 du circuit. Dans le cas du procédé Damascène, les tranchées 21 ont, par exemple, une profondeur de quelques centaines de nanomètres, ou moins. Le masque utilisé pour la gravure des tranchées 21 est retiré après cette gravure.

Un dépôt de matériau métallique, par exemple de cuivre, mais pouvant aussi être un dépôt d'aluminium, d'argent, de tungstène, de tantale, de titane, de molybdène, etc. ou d'un alliage, est alors effectué sur la surface S2 de façon à remplir intégralement les cavités 11 et les tranchées 21. Afin d'assurer le remplissage complet des cavités 11 et des tranchées 21, le dépôt de métal est poursuivi de façon à réaliser une couche 3 qui recouvre intégralement la surface S2, en formant un surplus de métal déposé par rapport au remplissage des cavités 11 et des tranchées 21.

Le surplus de métal déposé est alors retiré par polissage, en appliquant un disque de polissage plan contre la surface supérieure S3 de la couche 3, avec une force pression contrôlée orientée selon la direction D. Ce polissage utilise un liquide de polissage (ou «slurry») particulièrement adapté pour retirer rapidement le cuivre. Lors de ce polissage, la surface supérieure S3 de la couche métallique 3 est progressivement abaissée selon la direction D, en direction du substrat 1, tout en restant plane et parallèle à la surface S1 du substrat. Cette progression du polissage en conservant une surface S3 plane résulte du fait qu'une couche uniformément constituée de métal homogène est retirée. La configuration de la figure 1-b est alors obtenue, dans laquelle des inserts métalliques 12 et 22 remplissant respectivement les cavités 11 et les tranchées 21 sont isolés.

Le polissage est poursuivi dans des conditions inchangées, de façon à abaisser la surface S2 en direction du substrat 1, selon la direction D. Le matériau retiré est alors inhomogène, constitué de métal correspondant aux inserts 12 et 22 et de silice constituant la couche 2 en dehors des inserts 12 et 22. Grâce à une disposition adaptée des inserts 12 dans la portion P1, des vitesses moyennes d'enlèvement de matière sensiblement égales entre elles sont obtenues lors de cette seconde étape de polissage au niveau des deux portions P1 et P2. De cette façon, la surface S2 est abaissée régulièrement en restant plane et parallèle à la surface S1. Dans le mode de mise en oeuvre du procédé de l'invention rapporté ici, le polissage est arrêté lorsque la surface S2 arrive à une distance égale ou juste inférieure à la hauteur des fonds des inserts 12 par rapport à la surface S1. La configuration illustrée par la figure 1-c est alors obtenue. Dans cette configuration, la surface S2 est complètement dépourvue de toute partie métallique dans la portion P1, et comporte des inserts résiduels 20 dans la portion P2 qui forment, par exemple, des pistes de connexions électriques.

Dans une variante de mise en oeuvre, le polissage est arrêté avant que la surface S2 atteigne les fonds des inserts 12. Les parties métalliques résiduelles des inserts 12 sont alors retirées, lors d'une étape de retrait complémentaire, par un procédé autre que le polissage, par exemple un procédé de gravure humide ou de gravure sèche.

Une seconde couche de matériau isolant 4, pouvant être par exemple une seconde couche de silice, est alors déposée sur la surface S2 de la couche 2. Cette couche 4 recouvre en particulier les pistes 20. La surface supérieure S4 de la couche 4 est gravée, par exemple en utilisant la même méthode de gravure que celle utilisée au niveau de la surface supérieure S2 de la couche 2. Des tranchées 13 sont ainsi formées dans la surface S4, dans la portion P1. Eventuellement, des cavités et/ou des tranchées, non représentées, peuvent être aussi gravées dans la couche 4 dans la portion P2, pouvant être destinées à correspondre à des composants métalliques présents dans le circuit électrique final ou pour obtenir une surface S4 plane. La couche 4 ainsi gravée est alors recouverte d'une couche 5 de métal, par exemple de cuivre. Cette couche 5 comprend des volumes de métal qui remplissent complètement les tranchées 13, ainsi qu'un surplus de métal présent sur toute la surface supérieure S4 de la couche 4 (figure 1-d).

Le surplus de métal de la couche 5 est retiré, par exemple par polissage, de façon à découvrir la surface S4 du matériau isolant de la couche 4 entre les tranchées 13 remplies de métal. La figure 1-e illustre la configuration obtenue. Dans cette configuration, le substrat 1 est recouvert des deux couches de silice 2 et 4. La couche 2 incorpore les connexions métalliques 20 dans la portion P2, et la couche 4 incorpore ledit composant particulier, référencé 10 sur la figure 1-e, dans la portion P1. Grâce à la présence temporaire des inserts métalliques 12 lors du polissage de la couche de silice 2, la surface supérieure S2 de la couche 2 est plane, de façon à obtenir une base plane sous la couche 4 et pour le composant 10. Les inserts temporairement disposés dans la couche 2 dans la portion P1 ont été intégralement retirés, de telle sorte qu'un volume d'exclusion est présent sous le composant 10.

La figure 1-f est une vue de dessus du substrat 1 portant la structure élaborée en relation avec les figures 1-a à 1-e. Elle représente par conséquent la surface supérieure S4 de la seconde couche de silice 4, qui incorpore le composant 10 dans la portion P1. Sur cette figure, le composant 10 est une inductance en forme de spirale octogonale. Une connexion électrique, non représentée, reliant l'extrémité centrale de l'inductance 10 peut être agencée lors du procédé de fabrication de la structure précédemment décrit, ou peut être ajoutée selon toute autre méthode connue de l'homme du métier. Dans la portion P2, deux pistes parallèles 20 sont représentées en pointillés, correspondant à leur disposition au sein de la première couche de silice 2 recouverte par la seconde couche de silice 4.

Grâce au procédé de l'invention qui permet de ne pas avoir recours à un volume d'exclusion complémentaire, une distance inférieure à 200 µm, notamment inférieure à 50 µm, peut séparer les pistes 20 de l'inductance 10. Pour cela, lors de l'élaboration de la structure, une distance inférieure à 200 µm, de préférence inférieure à 50 µm tout en restant suffisante pour supprimer tout couplage électrostatique entre les pistes 20 et l'inductance 10, est ménagée entre certaines des tranchées 13 correspondant à l'inductance 10 et les tranchées 21 formées dans la couche de silice 2.

Les inserts temporaires 12 peuvent avoir des dimensions dans le plan de la surface S2 de l'ordre de 0,5 µm au moins, et présenter des distances de séparation entre deux inserts 12 voisins qui sont, par exemple, du même ordre de grandeur. De façon connue, la densité des inserts métalliques 12 est ajustée pour obtenir, à l'issue du polissage, une surface S2 plane, c'est à dire qui présente des variations de hauteur inférieures à 30-50 nanomètres selon la direction D. De même, une distance maximale de 10 à 50 µm sépare d'au moins un insert métallique chaque point du contour d'un composant métallique destiné à appartenir au circuit électrique final. Ainsi la surface S2 est maintenue rigoureusement plane lors du polissage. Compte tenu des dimensions de l'inductance 10 et des pistes 20, des masques de photolithographie utilisés pour élaborer les masques de gravure de la couche 2 peuvent ne présenter qu'une précision limitée. De même, le positionnement de ces masques de photolithographie par rapport à la surface S2 peut être aussi approximatif, ce qui permet d'utiliser des outils d'alignement simplifiés et donc moins onéreux. La durée nécessaire pour obtenir un tel alignement est alors réduite, ce qui diminue le temps de cycle et le coût correspondant aux étapes de gravure.

La figure 2-a représente une coupe d'un substrat 1 portant une structure élaborée selon le procédé de l'invention. Dans cette structure, quatre couches de matériau isolant, pouvant être chacune une couche de silice, sont superposées sur la surface S1 du substrat 1. Ces couches correspondent aux références 2, 2bis, 4 et 2ter, énumérées dans l'ordre à partir du substrat 1. Les couches 2, 2bis et 2ter comportent des composants métalliques respectifs 20, 20bis et 20ter dans la portion P2. Ces composants métalliques 20, 20bis et 20ter sont disposés au niveau des surfaces supérieures S2, S2bis et S2ter, respectivement des couches 2, 2bis et 2ter. La couche 4 incorpore un composant 10 qui peut être, de même que dans l'exemple précédent, une inductance composée de plusieurs spires disposées au niveau de la surface supérieure S4 de la couche 4. Le composant 10 est disposé dans la portion P1 du circuit. La portion P1 est par ailleurs dépourvue de toute autre partie métallique dans les quatre couches 2, 2bis, 4 et 2ter, de façon à présenter un volume d'exclusion autour du composant 10. Dans cet exemple, la couche supplémentaire de composants 20ter est disposée à un niveau supérieur, par rapport à la surface du substrat, au niveau de la couche 4 qui incorpore le composant 10.

Toutes les étapes d'élaboration de la structure représentée sur la figure 2-a ne sont pas décrites maintenant, étant donné qu'elles reprennent les étapes décrites dans l'exemple précédent, en référence aux figures 1-a à 1-e. Les couches 2, 2bis et 2ter sont analogues à la couche 2 de cet exemple précédent, et sont chacune obtenues par une séquence d'étapes identiques à celles déjà décrites en relation avec les figures 1-a, 1-b et 1-c.

A titre d'exemple, la figure 2-b illustre l'élaboration de la couche 2bis, en représentant la structure à l'issue du dépôt du matériau métallique. A ce niveau du procédé, la couche 2 est achevée, et la couche 2bis a été gravée de façon à présenter, au niveau de sa surface supérieure S2bis, d'une part des cavités 11bis correspondant à des inserts temporaires dans la portion P1, et d'autre part des tranchées 21 bis dans la portion P2, correspondant à des composants métalliques présents dans le circuit électrique final. Selon la conception du circuit électrique, les composants métalliques 20 et 20bis disposés dans les couches 2 et 2bis dans la portion P2 peuvent différer entre les deux couches. Les tranchées 21 bis diffèrent alors des tranchées 21 en fonction des composants métalliques auxquels elles correspondent respectivement. Les cavités 11 bis gravées dans la couche 2bis peuvent être identiques aux cavités 11 de la couche 2, étant donné qu'elles jouent un même rôle temporaire de compensation de la fraction de matériau métallique par rapport à la fraction de matériau isolant dans la portion P1. Cette compensation permet d'obtenir une surface S2bis plane à l'issue d'un polissage complet de la couche 2bis. La figure 2-b représente aussi la couche métallique 3bis de remplissage des cavités 11 bis et des tranchées 21 bis, avant le polissage de celle-ci.

La figure 2-c correspond à l'élaboration de la couche 2ter, considérée dans le même état intermédiaire d'élaboration que celui de la couche 2bis à la figure 2-b. La couche 4 est alors complète, et incorpore des tranchées 13 remplies de métal correspondant au composant 10. La couche 2ter présente des cavités 11ter et des tranchées 21ter, respectivement analogues aux cavités 11 bis et aux tranchées 21 bis. Ces cavités et tranchées sont remplies du matériau métallique de la couche supérieure 3ter.

Dans une variante du procédé de l'invention, une première couche de matériau isolant 2a, par exemple encore de silice, est élaborée sur la surface S1 d'un substrat 1. Des tranchées 21a sont gravées dans la surface supérieure S2a de la couche 2a. Les tranchées 21a sont situées en dehors d'une portion P1 du circuit, dans une portion P2 du circuit. L'ensemble est alors recouvert d'une couche 3a de matériau métallique, qui comble en particulier les tranchées 21 a, conformément à la figure 3-a.

On procède alors à un polissage de la couche métallique 3a, en utilisant, de même que précédemment, un liquide de polissage adapté pour obtenir une vitesse élevée d'enlèvement du métal. Afin d'assurer qu'aucune partie de la couche métallique 3a ne subsiste au-dessus de la couche de matériau isolant 2a en dehors des tranchées 21 a, le polissage est poursuivi, lors d'une étape de polissage complémentaire, de façon à enlever une partie supérieure du matériau isolant de la couche 2a. La surface supérieure S2a de la couche 2a est alors abaissée en direction du substrat 1, selon la direction D.

Après le polissage complémentaire, la surface S2a se retrouve à une hauteur plus grande dans la portion P2 que dans la portion P1, par rapport à la surface S1 du substrat 1. Cette différence de hauteur est due à la présence de matériau métallique dans les tranchées 21 a dans la portion P2, et à l'absence de matériau métallique dans la portion P1. En effet, la présence d'une fraction de matériau métallique au sein de matériau isolant, par exemple de silice, au niveau d'une surface d'abrasion augmente la vitesse globale d'enlèvement de matière, isolante ou métallique, tout en conservant une surface localement plane. II en résulte le dénivelé e représenté sur la figure 3-b.

On recouvre alors d'un masque de gravure M1 la surface S2a, comme l'illustre la figure 3-c. Ce masque couvre intégralement la portion P2 et comporte des ouvertures O1-O5 dans la portion P1. Ces ouvertures ont par exemple des côtés d'au moins 500 nanomètres environ, et sont distantes entre elles, par exemple, d'au moins 500 nanomètres. On pratique alors une gravure directionnelle par plasma (dite gravure sèche ou «plasma etching»). Lors de cette gravure, un flux directionnel F1 de particules accélérées, parallèle à la direction D, pénètre par les ouvertures O1-O5 et pulvérise progressivement une partie du matériau isolant de la couche 2a au droit des ouvertures O1-O5. Des cavités 14 sont alors obtenues (figure 3-d) situées aux emplacements des ouvertures O1-O5 du masque M1. Le masque M1 est ensuite retiré.

Le procédé de fabrication reprend alors les étapes déjà décrites. On dépose une couche 2 de matériau isolant sur la surface S2a (figure 3-e). Des conditions de dépôt adaptées, connues de l'homme du métier, sont adoptées lors de ce dépôt, afin d'obtenir une couche 2 dite «conforme». Une telle couche présente une surface supérieure S2 qui reproduit les creux et les reliefs de la surface S2a sur laquelle elle est déposée. Ainsi, la surface S2 est plane dans la portion P2, et présente des cavités 15 dans la portion P1 qui reproduisent les cavités 14 initialement présentes au niveau de la surface S2a. La surface S2 est donc identique à la surface S2a, mais décalée par rapport à celle-ci, selon la direction D, d'une distance correspondant à l'épaisseur de la couche 2.

Les cavités 15 ainsi obtenues sont analogues aux cavités de compensation 11 de la figure 1-a. Des tranchées 21 sont alors gravées dans la couche 2 dans la portion P2. La gravure est prolongée jusqu'à ce que les tranchées 21 présentent des fonds respectifs sensiblement parallèles à la surface S1 du substrat et situés à une hauteur inférieure, par rapport à la surface S1 et selon la direction D, à la hauteur du fond des cavités 15 par rapport à la surface S1. Lors de cette gravure des tranchées 21, la surface S2 est intégralement protégée dans la portion P1 par le masque de définition des contours des tranchées 21. Ce masque est ensuite retiré, et une couche de matériau métallique 3 est déposée de façon à remplir les cavités 15 et les tranchées 21 (figure 3-f).

Un polissage du matériau métallique 3 est alors opéré, de façon à ôter le matériau métallique en dehors des cavités 15 et des tranchées 21. Ce polissage est poursuivi jusqu'à ce que la surface S2 atteigne, ou dépasse juste, le fond des cavités 15. Les cavités 15 remplies de métal disparaissent alors progressivement au cours du polissage, et la configuration illustrée par la figure 3-g est obtenue. Lors de ce polissage, les cavités 15 remplies de métal constituent des inserts métalliques temporaires, analogues aux inserts 12 de la figure 1-b, grâce auxquels la surface S2 formée lors du polissage est plane.

L'élaboration de la structure au-dessus de la surface S2 peut alors être complétée selon les étapes déjà décrites en relation avec les figures 1-d et 1-e, ou en relation avec les figures 2-a à 2c.

La troisième mise en oeuvre du procédé de l'invention maintenant décrite est plus particulièrement destinée à la réalisation de plusieurs composants au sein d'une même couche de matériau isolant, dont l'un d'entre eux est particulièrement sensible aux couplages capacitifs ou inductifs. A titre d'exemple, ce composant sensible est une ligne de transport rapide de signaux électriques.

La figure 4-a représente un substrat de silicium 1 recouvert sur toute sa surface S1 d'une première couche 2 de matériau isolant sensiblement uniforme, par exemple de silice d'environ 1 µm d'épaisseur. Des cavités de compensation 11 et au moins une tranchée 21 sont ensuite gravées au niveau de la surface supérieure S2 de la couche 2, en déposant un masque de gravure sur la surface S2 initialement plane, le masque comportant des ouvertures correspondant respectivement aux cavités 11 et à la tranchée 21. La surface S2 ainsi partiellement recouverte est exposée à un plasma de gravure qui forme simultanément les cavités 11 dans au moins une portion P1 du substrat 1 et la tranchée 21 dans une portion P2 du substrat. A l'issue de la gravure, les cavités 11 et la tranchée 21 ont une même profondeur selon la direction D, de quelques centaines de nanomètres par exemple. De même que précédemment, la couche 2 est recouverte d'une couche métallique 3, de façon à combler les cavités 11 et la tranchée 21, avec un surplus de matériau métallique sur la surface S2, au dessus du niveau supérieur d'ouverture des cavités 11 et de la tranchée 21.

On retire alors par polissage le surplus de métal 3 jusqu'à découvrir la surface S2 entre les cavités 11 et autour de la tranchée 21 (figure 4-b). Eventuellement, ce polissage est prolongé au delà de l'apparition du matériau isolant de la couche 2 afin de garantir l'élimination de toute partie métallique de la surface S2 en dehors des cavités 11 et de la tranchée 21. Grâce à l'aménagement des cavités de compensation 11, la surface S2 est maintenue lors de ce polissage parallèle à la surface S du substrat 1 et, en dehors des cavités 11 et de la tranchée 21, à une hauteur selon la direction D uniforme sur l'ensemble des deux portions P1 et P2. Les cavités 11 et la tranchée 21 deviennent alors des inserts métalliques isolés les uns des autres, respectivement 12 et 20. L'insert 20 constitue un composant définitif du circuit final.

Un masque de résine M2 est alors réalisé par lithographie dans la portion P2, de façon à recouvrir au moins l'insert 20. Aucun masque n'est laissé dans la portion P1. La surface S2 ainsi partiellement recouverte du masque M2 est exposée à un plasma de gravure sélective du matériau métallique 3. Un tel plasma comprend un flux F2 de particules accélérées selon la direction D au moyen d'une tension électrique adaptée pour graver le matériau métallique 3 sans graver le matériau de la couche 2, plus résistant à la gravure que le matériau métallique 3. Les inserts 12 sont ainsi complètement vidés du matériau métallique 3. Une gravure chimique permet également d'enlever complètement le matériau métallique 3. Le masque M2 est ensuite retiré.

Une seconde couche de matériau isolant 4, par exemple encore de silice, est déposée au dessus de la couche 2 (figure 4-c). La couche 4 est polie mécaniquement de façon à obtenir une surface supérieure S4 plane, parallèle à la surface S.

Une autre méthode d'obtention de la surface S4 plane et parallèle à la surface S, qui n'utilise pas de polissage de la couche 4 après son dépôt, consiste à avoir formé préalablement dans la couche 2 des cavités de compensation 11 selon un motif suffisamment serré pour que ce motif n'apparaisse pas au niveau de la surface S4 lors du dépôt de la couche 4. La surface S4 est alors directement obtenue plane lors du dépôt du matériau isolant 4, permettant d'éviter l'étape de polissage. Ceci est en particulier le cas lorsque des cavités 11 ont été formées dans la couche 2, par exemple carrées, ayant des côtés d'au plus 400 nanomètres avec une densité correspondant à un taux d'occupation de la surface S2 d'au moins 25%.

Des cavités de compensation 16 et une tranchée 13 sont alors formées dans la couche 4 dans la portion P1, ainsi qu'au moins une autre tranchée 41 dans la portion P2. Les cavités 16 et les tranchées 13 et 41 sont préférablement formées simultanément lors d'une unique étape de gravure en utilisant un masque de gravure déposé sur la surface S4 qui comporte des ouvertures correspondant respectivement aux cavités 16 et aux tranchées 13 et 41. Le mode de gravure utilisé est par exemple une gravure sèche directionnelle. A l'issue de la gravure, les cavités 16 et les tranchées 13 et 41 ont des profondeurs identiques selon la direction D, fixées par la durée de l'étape de gravure. La forme de la tranchée 13 correspond à celle voulue pour la ligne de transport rapide de signaux électriques au sein du circuit final. De même que dans les mises en oeuvre du procédé précédemment décrites, la tranchée 41 correspond un composant définitif dans la seconde portion du circuit.

On recouvre alors la surface S4 d'un autre matériau métallique 5, (figure 4-c), de façon à remplir entièrement les cavités 16 et les tranchées 13 et 41, avec un surplus de matériau métallique présent au dessus du niveau supérieur d'ouverture des cavités 16 et des tranchées 13 et 41. De la même façon que celle décrite plus haut, l'excès de matériau métallique 5 est retiré par polissage jusqu'à découvrir la couche 4 dans la portion P2 en dehors de la tranchée 41 et dans la portion P1 autour de la tranchée 13. Les tranchées 13 et 41 sont alors isolées et deviennent respectivement les inserts métalliques 10 et 40.

Un masque M3 est alors déposé au dessus de la portion P2 du circuit, qui recouvre en particulier l'insert 40, et au dessus de l'insert 10 dans la portion P1 (figure 4-d). Le matériau conducteur 5 est enlevé par gravure sélective dans les parties de la surface S4 non recouvertes par le masque M3. Cet enlèvement peut être effectué par gravure sèche au moyen d'un flux directionnel F3 de particules envoyées sur la surface S4 parallèlement à la direction D. II peut aussi être effectué par gravure chimique au moyen d'une solution liquide incorporant des réactifs appropriés pour dissoudre le matériau métallique 5. L'étape de gravure est poursuivie jusqu'à enlever intégralement le matériau métallique 5 des cavités de compensation 16.

Le masque M3 est alors retiré, en laissant intacts les inserts 10 et 40, comme l'illustre la figure 4-e. Une troisième couche de matériau isolant 2ter peut ensuite être déposée sur la surface S4, en recouvrant les inserts 10 et 40, puis la surface supérieure S2ter de la couche 2ter est aplanie par polissage de la même manière que pour la couche 2. De même que pour la couche 4, la surface S2ter peut être directement obtenue plane et parallèle à la surface S lors du dépôt de la couche 2ter, sans effectuer de polissage, si les cavités de compensations 16 formées dans la couche 4 constituent un motif suffisamment serré.

L'élaboration du circuit peut ensuite être poursuivie de la façon déjà décrite en référence à la figure 2-c, en particulier pour la réalisation d'un insert 20ter dans la portion P2 correspondant à un composant du circuit final (figure 4-f).

Dans ce mode de réalisation, une ligne de transport rapide de signaux électriques a été prise pour exemple de composant isolé dans la portion P1, afin d'éviter qu'elle soit perturbée par d'autres composants disposés trop proches d'elle sur le substrat du circuit. De façon identique, le procédé peut être appliqué à la réalisation d'une antenne ou d'un condensateur nécessitant des précautions d'isolement identiques.

Les exemples précédents de mise en oeuvre du procédé de l'invention ont été décrits, pour raison de simplicité, dans le cadre du procédé Damascène. Chacune des étapes du procédé peut être combinée identiquement avec le procédé «dual Damascène». Cette combinaison avec le procédé «dual Damascène» met en oeuvre de façon analogue des inserts disposés dans la portion du circuit destinée à porter un composant sensible aux couplages électrostatiques. Ces inserts sont ensuite retirés de façon à ménager un volume d'exclusion sous, et éventuellement sur, le composant sensible. L'utilisation du procédé «dual Damascène» permet la réalisation de circuits électriques plus complexes que le procédé Damascène, sans augmenter la surface du substrat nécessaire pour porter ces circuits.

A titre d'illustration, les figures 5-a et 5-b correspondent respectivement aux figures 1-a et 1-b dans le cadre du procédé «dual Damascène». Elles comprennent des éléments identiques à ceux des figures 1-a et 1-b, hormis la structure de la couche 2. Dans les figures 5-a et 5-b, la couche 2 comprend trois couches élémentaires 6, 7 et 8 superposées, constituées de matériaux respectifs isolants électriquement. Les couches élémentaires 6 et 8 sont, par exemple, en silice SiO₂, et possèdent des épaisseurs respectives de quelques centaines de nanomètres. La couche intermédiaire 7, appelée couramment couche d'arrêt (ou «stop layer») est, par exemple, en nitrure de silicium Si₃N₄, et présente une épaisseur de quelques dizaines de nanomètres, par exemple. Dans le procédé «dual Damascène», la couche d'arrêt 7 n'est pas altérée par le procédé de gravure utilisé pour réaliser des cavités et des tranchées dans les couches élémentaires de silice 6 et 8.

De façon connue, des tranchées 21 sont gravées dans la couche élémentaire 8, sur toute l'épaisseur de celle-ci, qui présentent des prolongements 23 dans la couche élémentaire 6. Ces prolongements 23 s'étendent au travers de la couche d'arrêt 7. De la même façon que celle décrite en référence à la figure 1-a, des cavités 11 sont gravées dans la couche élémentaire 8. L'ensemble des cavités 11 et des tranchées 21, ainsi que les prolongements 23, sont comblés de métal lors du dépôt de la couche métallique 3.

Le polissage déjà décrit est effectué ensuite, qui retire les parties de métal présentes au-dessus de la couche élémentaire 8 en dehors des cavités 11 et des tranchées 21. Les inserts métalliques 12 et 22 sont alors formés, isolés entre eux, sans modification des prolongements 23. Les inserts 12 permettent de conserver une surface S2 plane lors de la poursuite du polissage, tout en étant complètement éliminés. Les inserts 22, au sein de la couche élémentaire 8, constituent, par exemple, des pistes métalliques de connexions électriques. Les prolongements 23, au sein de la couche élémentaire 6, constituent des vias qui réalisent des connexions électriques entre des pistes et des composants superposés selon la direction D.

Le procédé précédemment décrit est bien adapté à la réalisation de circuits intégrés destinés à des applications diverses. Un tel circuit peut constituer par exemple un microprocesseur, un microcontrôleur, un organe périphérique, un circuit intégré d'application spécifique (ASIC) etc., incorporant une plus ou moins grande diversité de fonctions. La figure 6 illustre un tel circuit 100 faisant partie d'un dispositif électronique 200. Ce dispositif 200 consiste par exemple en un ordinateur, un appareil périphérique, un équipement de communication fixe ou mobile, un équipement électronique domestique, professionnel ou industriel, un équipement embarqué dans un véhicule, un instrument de mesure ou de contrôle, etc., dans lequel le circuit 100 est monté par des techniques bien connues de l'homme du métier. Il peut aussi consister en une sous-unité, telle que par exemple une carte électronique, destinée à faire partie d'un système plus vaste.

## Revendications

1. Procédé de fabrication d'un circuit électrique, dans lequel on exécute des traitements par couche successifs au-dessus d'un substrat (1) pour réaliser au moins un premier composant (10) dans une première portion (P1 ) du circuit et des seconds composants (20) dans une seconde portion (P2) du circuit adjacente à la première portion, dans lequel au moins un premier des traitements par couche comprend les étapes suivantes :
- former, dans un premier matériau isolant électrique (2, 2bis, 2ter) présent au-dessus du substrat, des cavités de compensation (11, 11bis, 11ter ; 15) dans la première portion du circuit et des tranchées (21, 21 bis, 21ter) correspondant à certains au moins des seconds composants dans la seconde portion du circuit ;
- recouvrir le premier matériau isolant d'un premier matériau conducteur (3, 3bis, 3ter) de façon à remplir sensiblement les cavités de compensation et les tranchées formées dans le premier matériau isolant ;
- polir le premier matériau conducteur jusqu'à découvrir une partie du premier matériau isolant dans la seconde portion ; et
- enlever le premier matériau conducteur dans la première portion,
et dans lequel au moins un second des traitements par couche comprend les étapes suivantes :
- former, dans un second matériau isolant électrique (4) présent au-dessus du substrat, au moins une tranchée (13) correspondant au premier composant (10) dans la première portion du circuit ;
- recouvrir le second matériau isolant d'un second matériau conducteur (5) de façon à remplir sensiblement la tranchée formée dans la première portion ; et
- retirer partiellement le second matériau métallique jusqu'à découvrir une partie du second matériau isolant dans la première portion.

2. Procédé selon la revendication 1, dans lequel ledit premier traitement par couche est exécuté avant ledit second traitement par couche, le second matériau isolant étant déposé par dessus le premier matériau isolant.

3. Procédé selon la revendication 2, dans lequel au moins un troisième des traitements par couche comprend les étapes suivantes :
- former, dans un troisième matériau isolant électrique (2a) présent au dessus du substrat, des tranchées (21 a) correspondant à des seconds composants dans la seconde portion du circuit ;
- recouvrir le troisième matériau isolant d'un troisième matériau conducteur (3a) de façon à remplir sensiblement les tranchées formées dans le troisième matériau isolant ;
- polir le troisième matériau conducteur jusqu'à découvrir une partie du troisième matériau isolant dans la seconde portion, de telle sorte que la surface (S2a) du troisième matériau isolant se retrouve plus haute dans la première portion que dans la seconde portion ;
- graver des premières cavités (14) dans le troisième matériau isolant dans la première portion du circuit, de façon telle que les premières cavités aient leurs fonds plus profonds que le niveau de ladite la surface (S2a) du troisième matériau isolant dans la seconde portion du circuit,
dans lequel ledit premier traitement par couche, exécuté après ledit troisième traitement par couche, commence par une étape de dépôt du premier matériau isolant (2) sous forme d'une couche recouvrant le troisième matériau isolant dans les première et seconde portions du circuit de façon que la surface (S2) du premier matériau isolant présente des secondes cavités (15) sensiblement conformes aux premières cavités (14) et constituant lesdites cavités de compensation.

4. Procédé selon l'une quelconque des revendications 1 à 3, dans lequel le retrait partiel dudit second matériau conducteur (5) comprend un polissage, une gravure chimique au moyen d'une solution liquide ou une gravure sèche par plasma.

5. Procédé selon l'une quelconque des revendications 1 à 4, dans lequel les cavités (11, 11bis, 11 ter) formées dans le premier matériau isolant (2, 2bis, 2ter) ont une profondeur plus petite que les tranchées (21, 21bis, 21 ter) formées dans le premier matériau isolant.

6. Procédé selon l'une quelconque des revendications 1 à 5, dans lequel l'enlèvement dudit premier matériau conducteur (3, 3bis, 3ter) dans la première portion comprend une étape utilisant une gravure chimique au moyen d'une solution liquide ou une gravure sèche par plasma.

7. Procédé selon la revendication 5, dans lequel l'enlèvement dudit premier matériau conducteur (3, 3bis, 3ter) dans la première portion comprend une étape de polissage.

8. Procédé selon l'une quelconque des revendications 1 à 4, dans lequel, lors dudit second traitement par couche :
- des cavités de compensation (16) sont formées en outre dans ledit second matériau isolant (4) ;
- les cavités de compensation formées dans ledit second matériau isolant sont sensiblement remplies par le second matériau conducteur (5) ;
et dans lequel ledit second traitement par couche comprend en outre, après le retrait partiel du second matériau conducteur (5), un enlèvement du second matériau conducteur des cavités de compensation (16) formées dans ledit second matériau isolant.

9. Procédé selon la revendication 8, dans lequel l'enlèvement du second matériau conducteur (5) des cavités de compensation (16) formées dans ledit second matériau isolant est effectué en masquant la tranchée (13) correspondant au premier composant (10).

10. Procédé selon la revendication 8 ou 9, dans lequel l'enlèvement du second matériau conducteur (5) des cavités de compensation (16) formées dans ledit second matériau isolant comprend une gravure chimique au moyen d'une solution liquide ou une gravure sèche par plasma.

11. Procédé selon l'une quelconque des revendications 8 à 10, dans lequel les cavités de compensation (16) formées dans ledit second matériau isolant (4) sont formées simultanément à la tranchée (13) correspondant au premier composant (10).

12. Procédé selon l'une quelconque des revendications 8 à 11, dans lequel, lors dudit second traitement par couche, des tranchées (41) correspondant à certains au moins des seconds composants sont en outre formées dans ledit second matériau isolant (4) dans la seconde portion du circuit, et dans lequel le retrait partiel du second matériau conducteur (5) est effectué de façon à découvrir en outre une partie du second matériau isolant (4) dans la seconde portion.

13. Procédé selon la revendication 12, dans lequel l'enlèvement du second matériau conducteur (5) des cavités de compensation (16) formées dans ledit second matériau isolant est effectué en masquant la tranchée (13) correspondant au premier composant (10) et les tranchées (41 ) correspondant à certains au moins des seconds composants.

14. Procédé selon l'une quelconque des revendications précédentes, dans lequel ledit premier composant (10) est une inductance, une antenne, une ligne de transport rapide de signaux électriques, ou un condensateur.

15. Procédé selon l'une quelconque des revendications 1 à 14, dans lequel lesdits premier (2, 2bis, 2ter) et/ou second (4) matériaux isolants électrique disposés en couches respectives sont polis avant la formation des cavités de compensation (11, 11 bis, 11ter ; 15) et des tranchées (21, 21 bis, 21 ter, 13) respectivement dans chacun desdits premier et/ou second matériaux isolants.

16. Procédé selon l'une quelconque des revendications 1 à 14, dans lequel lesdits premier (2, 2bis, 2ter) et/ou second (4) matériaux isolants électrique sont déposés sous forme de couches respectives ayant chacune une surface supérieure plane à l'issue du dépôt de chacun desdits premier et/ou second matériaux isolants.
